# EUROPÄISCHE PATENTSCHRIFT

(11) **EP 2 149 763 B1**
(45) Veröffentlichungstag und Bekanntmachung des Hinweises auf die Patenterteilung: **28.06.2017**
(21) Anmeldenummer: 09166546.3
(22) Anmeldetag: 28.07.2009
(51) Int. Cl.: F24H 9/20, H05K 5/00, H05K 7/14

(54) **Vorrichtung zur Aufnahme einer Steuerelektronik**
Apparatus for receiving a control electronic system
Dispositiv pour recevoir un système électronique de commande

(30) Priorität: 31.07.2008 DE 102008035904
(43) Veröffentlichungstag der Anmeldung: 03.02.2010
(73) Patentinhaber: BSH Hausgeräte GmbH, 81739 München (DE)
(72) Erfinder: Bauer, Franz, 83374 Traunwalchen (DE); Englisch, Christian, 83324 Ruhpolding (DE); Gruber, Michael, 83362 Surberg (DE)

(56) Entgegenhaltungen:
- WO-A1-2007/113613
- JP-A- 2001 223 526
- US-B1- 7 046 922

## Beschreibung

Die vorliegende Erfindung betrifft eine Vorrichtung zur Aufnahme einer Steuerelektronik eines elektronischen Durchlauferhitzers, welcher eine Haube umfasst, die Vorrichtung wenigstens umfassend einen Lagerbock, welcher die Steuerelektronik umfasst.

Vorrichtungen zur Aufnahme einer Steuerelektronik eines elektronischen Durchlauferhitzers sind im Stand der Technik bekannt. Dabei weisen die bestehenden Vorrichtungen den Nachteil auf, dass die Steuerelektronik an der Haube befestigt werden muss, um ein Verrutschen zu verhindern. Dies erhöht die Montagekosten einerseits und gestattet es andererseits nicht, mögliche Fertigungstoleranzen auszugleichen. Eine solche Vorrichtung ist beispielsweise in der US 7 046 922 B1 offenbart.

Der Erfindung liegt die Aufgabe zu Grunde, eine verbesserte Vorrichtung zur Aufnahme einer Steuerelektronik eines elektronischen Durchlauferhitzers, der eine Haube umfasst, zur Verfügung zu stellen, die montagefreundlich und kostengünstig zu erstellen ist.

Gelöst wird diese Aufgabe erfindungsgemäß mit den Merkmalen des Patentanspruches 1.

Vorteilhafte Aus- und Weiterbildungen der Erfindung, welche einzeln oder in Kombination miteinander eingesetzt werden können, sind Gegenstand der Unteransprüche.

Die erfindungsgemäße Vorrichtung zur Aufnahme einer Steuerelektronik baut auf gattungsgemäßen Vorrichtungen dadurch auf, dass der Lagerbock wenigstens ein Federbein aufweist, mittels dessen die Steuerelektronik gegen die Haube pressbar ist. Dadurch wird eine gegenüber dem Stand der Technik deutlich verbesserte Montagefreundlichkeit erzielt.

Dadurch, dass der Lagerbock gegen die Haube pressbar ist, wird der Lagerbock an der Haube fixiert, und ein Verrutschen verhindert.

In einer bevorzugten Variante umfasst die Elektronik wenigstens ein Display. Dadurch, dass das Federbein die Steuerelektronik gegen die Haube presst, wird erreicht, dass die Tasten, die auf einer Steuerplatine angebracht sind, nah an die Betätigungsfelder der Haube herangerückt werden, und der Schaltweg verkürzt wird. Auf Grund der Federbeine wird bei Tastenbetätigung ein zu hartes Schalten der Druckknöpfe verhindert. Durch die Vierpunktauflage ist jederzeit die definierte Lage des Displays bzw. der Taste zu den vorgesehenen Kontaktstellen zu der Haube definiert. Dadurch kann im Gegensatz zu einer, an der Haube fest montierten Steuerelektronik mit Display, auf eine, für diesen Montagefall nötige, Steuerleitung verzichtet werden. Zusätzlich können auf Grund der Federwirkung Fertigungstoleranzen ausgeglichen werden.

Als besonders vorteilhaft hat es sich erwiesen, wenn die Haube ein Sichtfenster umfasst.

Von besonderem Vorteil ist es dabei, wenn die Vorrichtung ein Display umfasst, welches gegen das Sichtfenster pressbar ist. Somit wird einerseits gewährleistet, dass die Tasten bzw. Druckknöpfe des Displays gut zu sehen sind, und andererseits, dass die Tasten bzw. die Druckknöpfe gegen Verschmutzen und Feuchtigkeit geschützt sind.

In einer weitern bevorzugten Ausführungsform weist die Vorrichtung zur Aufnahme einer Steuerelektronik einen Lagerbock auf, der Führungen und/oder Gegenrastungen für wenigstens einen Stecker aufweist. Hierdurch lassen sich in sicherer und kostengünstiger Weise Elektroleitungen montieren.

Von besonderem Vorteil ist es dabei, wenn die Vorrichtung zur Aufnahme einer Steuerelektronik ein Federbein aufweist, welches eine Verrohrung und/oder eine Verkabelung umfasst.

Als vorteilhaft hat es sich insbesondere erweisen, wenn die Vorrichtung zur Aufnahme einer Steuerelektronik wenigstens einen Rasthaken aufweist, mittels dessen sie mit dem Durchlauferhitzer verbindbar ist. Dadurch kann die Vorrichtung schnell mit dem Durchlauferhitzer bzw. dessen Verrohrung verbunden und wieder von diesem getrennt werden.

In einer weiteren Bevorzugten Ausführungsform weist die Vorrichtung wenigstens einen Führungsstift auf, mittels dessen der Rasthaken stabilisierbar ist.

Die Erfindung lässt sich zutreffend wie folgt beschreiben:
Zweck der Erfindung ist die Aufnahme einer Steuerelektronik mit oder ohne Display für einen elektrisch gesteuerten Durchlauferhitzer. Hierzu wurde eine Aufnahme aus Kunststoff entwickelt, die die Aufgabe hat, das Display bzw. die Steuerelektronik an das Sichtfenster der Haube des Durchlauferhitzers zu drücken. Zusätzlich sollen die Tasten, die an der Steuerplatine angebracht sind, nah an die Betätigungsfelder der Haube herangedrückt werden, um den Schaltweg zu verkürzen. Die Erfindung stellt einen Lagerbock dar, der einerseits die Elektronik mit oder ohne Display aufnehmen kann und andererseits mittels Federbein an die Haube gepresst werden kann. Aufgrund der Federbeine wird bei der Tastenbetätigung ein zu hartes Schalten der Druckknöpfe verhindert. Durch die Vierpunktauflage ist jederzeit die definierte Lage des Displays bzw. der Taste zu den vorgesehenen Kontaktstellen zu der Haube definiert. Dadurch, dass die Federbeine die Steuerelektronik mit oder ohne Display nah an die vorgesehenen Kontaktstellen der Haube heranführen, kann im Gegensatz zu einer, an der Haube fest montierten Steuerelektronik mit oder ohne Display, auf eine, für diesen Montagefall nötige Steuerleitung, verzichtet werden. Aufgrund der Federwirkung können Fertigungstoleranzen ausgeglichen werden. der Lagerbock überbrückt den Hohlraum zwischen Heizblock und Haube. Eine Verrohrung und/oder eine Verkablung kann unter den Federbeinen durchgeführt werden. Dabei weist der Lagerbock Führungen und Gegenrastungen für verschiedene Stecker auf. Zusätzlich kann dabei die Verrastung am Heizblock so ausgelegt sein, dass ein Wegausgleich sowohl beim Aufsetzen der Haube als auch bei Fertigungstoleranzen der Haube realisiert werden kann ohne die Rastfunktion zu verlieren.

Weitere Vorteile und Ausgestaltungen der Erfindung werden im Folgenden anhand verschiedener Ausführungsbeispiele, auf welche die vorliegende Erfindung jedoch nicht beschränkt ist, sowie unter Bezugnahme auf die beiliegenden Zeichnungen erläutert. Bei der nachfolgenden Beschreibung der bevorzugten Ausführungsformen der vorliegenden Erfindung bezeichnen gleiche Bezugszeichen gleiche oder vergleichbare Komponenten.

Darin zeigen schematisch:
- Fig. 1: eine Querschnittszeichnung einer bevorzugte Ausführungsform der Vorrichtung;
- Fig. 2: eine schematische Frontansicht eines Durchlauferhitzers mit eingesetztem Display;
- Fig. 3: eine Längsschnittdarstellung einer Ausführungsform der Vorrichtung;
- Fig. 4: eine perspektivische Darstellung eines Heizblocks eines Durchlauferhitzers mit aufgesetzter Vorrichtung;
- Fig. 5: eine Vorderansicht einer Vorrichtung;
- Fig. 6: eine Seitenansicht einer Vorrichtung; sowie
- Fig. 7: eine perspektivische Schrägansicht einer Vorrichtung.

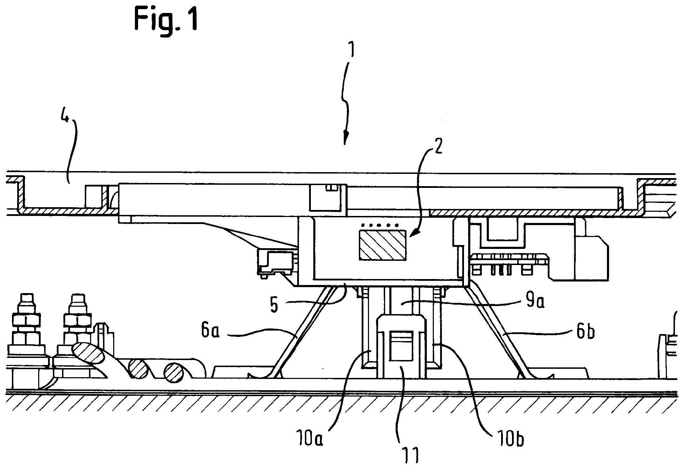

Anhand der in Fig. 1 gezeigten Querschnittszeichnung werden die einzelnen Komponenten der Vorrichtung zur Aufnahme einer Steuerelektronik illustriert. Die Vorrichtung 1 zur Aufnahme einer Steuerelektronik 2 weist einen Lagerbock 5 auf, wobei der Lagerbock 5 die Steuerelektronik 2 aufnimmt. Weiterhin weist die Vorrichtung ein Federbein 6a bzw. 6b auf, mittels dessen der Lagerbock 5 sowie die darin integrierte Steuerelektronik gegen eine Haube 4 pressbar ist.

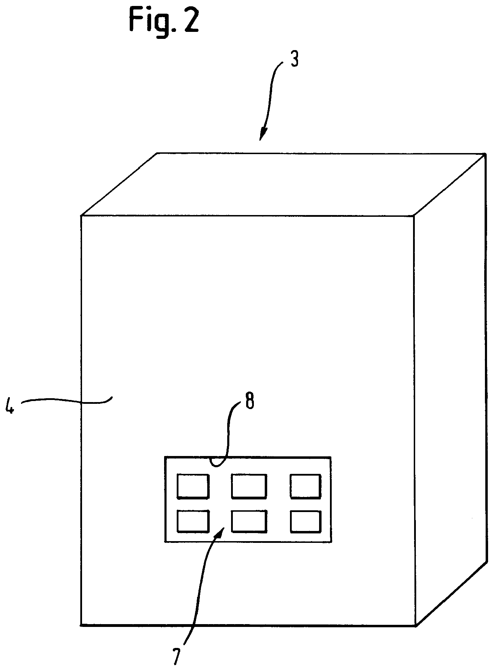

Fig. 2 zeigt einen Durchlauferhitzer 3, dessen Frontseite durch eine Haube 4 verschlossen ist. Die Haube 4 weist ein Sichtfenster 8 auf, gegen das ein Display 7 gepresst werden kann. Dadurch wird einerseits eine gute Zugänglichkeit der Displaytasten sowie andererseits ein guter Schutz durch das aufliegende Displayfenster erzielt.

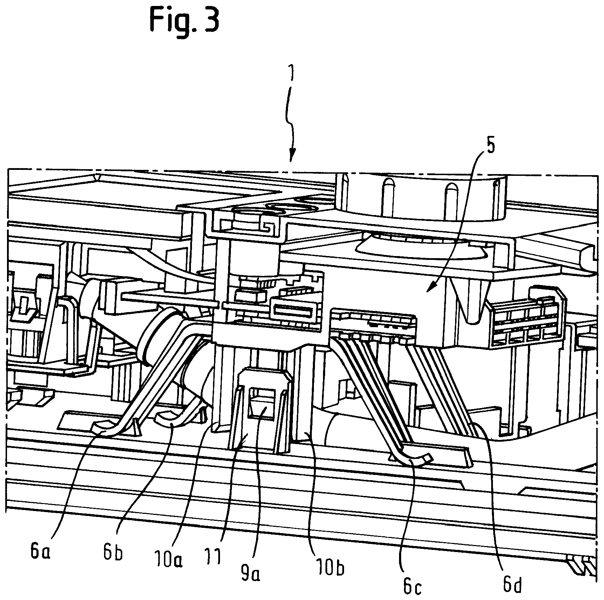

Fig. 3 zeigt eine Längsschnittdarstellung einer Ausführungsform der Vorrichtung 1. Zu erkennen sind 4 Federbeine 6a, 6b, 6c sowie 6d die in einem begrenzten Maß flexibel sind, so dass sich bei Belastung der Vorrichtung 1 die Federbeine an ihrem von einem Lagerbock 5 entfernten Seite auseinander bewegen bzw. auseinander spreizen. Mittels eines Rasthakens 9a kann der Lagerbock mit dem Durchlauferhitzer verrastet werden. Darüber hinaus weist die Vorrichtung 1 Führungsstifte 10 a, 10b, 10c und 10d auf, mittels dessen der Lagerbock stabilisiert wird und der Rasthaken geführt wird.

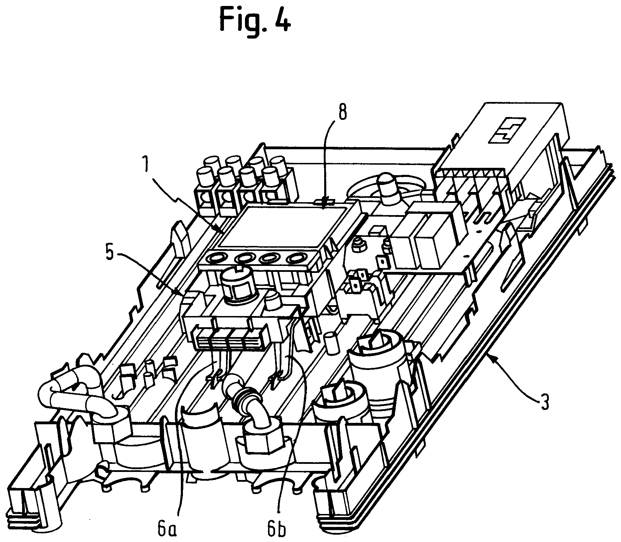

Fig. 4 zeigt eine perspektivische Darstellung eines Heizblocks eines Durchlauferhitzers 3 mit aufgesetzter Vorrichtung 1. Dabei umfasst die Vorrichtung 1 einen Lagerbock 5 sowie ein Sichtfenster 8. weiter zu erkennen sind Federbeine 6a und 6b, mittels derer der Lagerbock 5 flexibel gelagert ist.

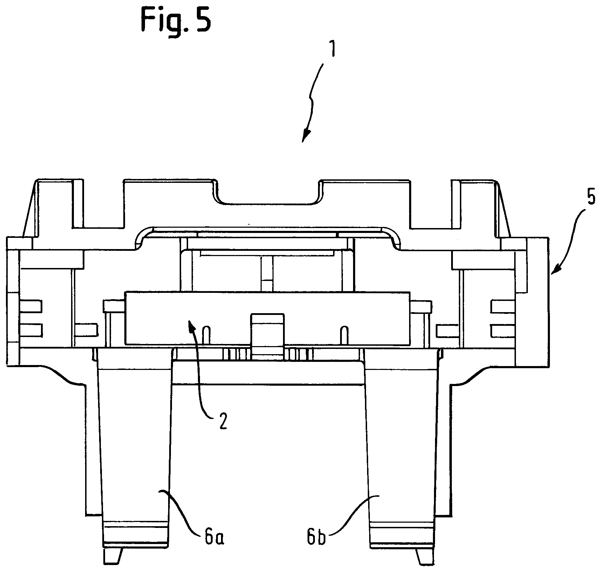

Fig. 5 zeigt eine Vorderansicht einer Vorrichtung 1, die einen Lagerbock 5 umfasst. Dieser umfasst in seinem Innern eine Elektronik 2. Darüber hinaus weist der Lagerbock Federbeine 6a und 6b auf.

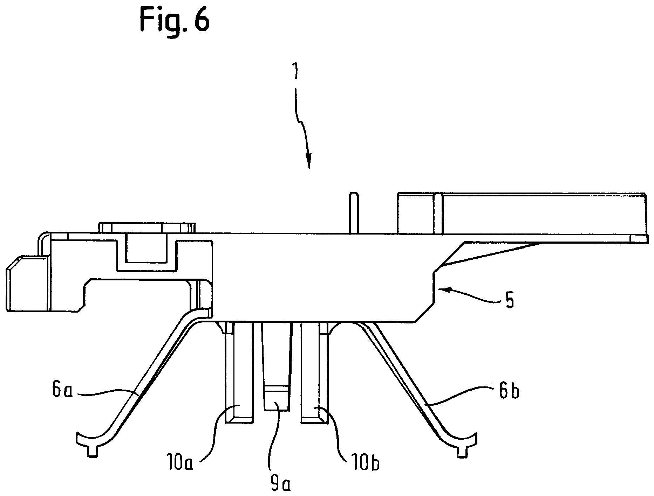

Fig. 6 zeigt eine Seitenansicht einer Vorrichtung 1, die einen Lagerbocks 5 umfasst. Auf ihrer Unterseite weist die Vorrichtung 1 Federbeine 6a und 6b auf, darüber hinaus einen Rasthaken 9a, mit dem der Lagerbock 5 mit einem Durchlauferhitzer verrastet werden kann. Die Vorrichtung 1 weist darüber hinaus Führungsstifte 10 a und 10b auf, die das Rastelement stabilisieren und ein Verrutschen innerhalb eines Gegenstücks, mit dem das Rastelement 9a verrastet wird, zu vermeiden.

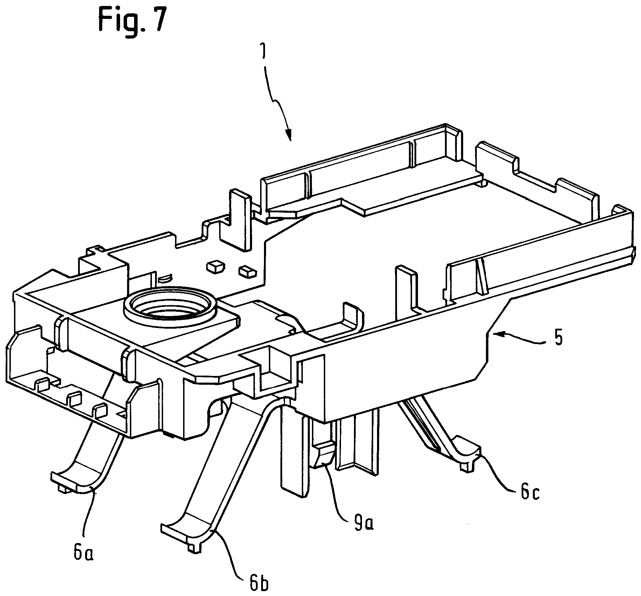

Fig. 7 eine perspektivische Schrägansicht einer Vorrichtung 1, die einen Lagerbock 5 umfasst. Zu erkennen sind Federbeine 6a, 6b sowie 6c. auf seiner Unterseite weist der Lagerbock 5 Federbeine 6a, 6b und 6c auf. Ebenfalls auf seiner Unterseite weist der Lagerbock 5 ein Rastelement 9a auf, mit dem der Lagerbock 5 mit einem Durchlauferhitzer verrastet werden kann. Das Rastelement 9a wird durch Führungsstifte 10 a und 10 b stabilisiert.
Die erfindungsgemäße Vorrichtung vereint in preisgünstiger und montagefreundlicher Weise Sicherheit und Bedienkomfort.

### BEZUGSZEICHENLISTE:

- 1: Vorrichtung zur Aufnahme einer Steuerelektronik
- 2: Steuerelektronik; Elektronik
- 3: Durchlauferhitzer
- 4: Haube
- 5: Lagerbock
- 6a; 6b; 6c; 6d: Federbein
- 7: Display
- 8: Sichtfenster
- 9a; 9b; 9c: Rasthaken
- 10a; 10b; 10c; 10d: Führungsstift
- 11: Gegenstück

## Patentansprüche

1. Vorrichtung (1) zur Aufnahme einer Steuerelektronik (2) eines elektronischen Durchlauferhitzers (3), wobei der Durchlauferhitzer wenigstens eine Haube (4) umfasst, **dadurch gekennzeichnet, dass** die Vorrichtung (1) wenigstens einen Lagerbock (5) umfasst, welcher eine Steuerelektronik (2) umfasst, wobei die Vorrichtung (1) wenigstens ein Federbein (6a; 6b; 6c; 6d) aufweist, mittels dessen der Lagerbock (5) gegen die Haube (4) pressbar ist.

2. Vorrichtung (1) zur Aufnahme einer Steuerelektronik (2) nach Anspruch 1, **dadurch gekennzeichnet, dass** die Steuerelektronik (2) wenigstens ein Display (7) umfasst.

3. Vorrichtung (1) zur Aufnahme einer Steuerelektronik (2) nach Anspruch 1 oder 2, **dadurch gekennzeichnet, dass** die Vorrichtung die wenigstens eine Haube des Durchlauferhitzers umfasst, wobei die wenigstens eine Haube ein Sichtfenster (8) umfasst.

4. Vorrichtung (1) zur Aufnahme einer Steuerelektronik (2) nach Anspruch 3, **dadurch gekennzeichnet, dass** das Display (7) gegen das Sichtfenster (8) pressbar ist.

5. Vorrichtung (1) zur Aufnahme einer Steuerelektronik (2) nach einem der vorhergehenden Ansprüche, **dadurch gekennzeichnet, dass** der Lagerbock (5) Führungen und/oder Gegenrastungen für wenigstens einen Stecker aufweist.

6. Vorrichtung (1) zur Aufnahme einer Steuerelektronik (2) nach einem der vorhergehenden Ansprüche, **dadurch gekennzeichnet, dass** das Federbein (6a;6b) eine Verrohrung und/oder eine Verkabelung umfasst.

7. Vorrichtung (1) zur Aufnahme einer Steuerelektronik (2) nach einem der vorhergehenden Ansprüche, **dadurch gekennzeichnet, dass** die Vorrichtung wenigstens einen Rasthaken (9a; 9b; 9c; 9d) aufweist, mittels dessen die Vorrichtung mit dem Durchlauferhitzer (3) verbindbar ist.

8. Vorrichtung (1) zur Aufnahme einer Steuerelektronik (2) nach einem der vorhergehenden Ansprüche, **dadurch gekennzeichnet, dass** die Vorrichtung wenigstens einen Führungsstift (10a; 10b; 10c; 10d) aufweist, mittels dessen der Rasthaken (9a; 9b; 9c; 9d) stabilisierbar ist.

## Claims

1. Apparatus (1) for receiving a control electronics system (2) of an electronic continuous flow heater (3), wherein the continuous flow heater comprises at least one hood (4), **characterised in that** the apparatus (1) comprises at least one bearing block (5), which comprises a control electronics system (2), wherein the apparatus (1) has at least one spring strut (6a; 6b; 6c; 6d), by means of which the bearing block (5) can be pressed against the hood (4).

2. Apparatus (1) for receiving a control electronics system (2) according to claim 1, **characterised in that** the control electronics system (2) at least comprises a display (7).

3. Apparatus (1) for receiving a control electronics system (2) according to claim 1 or 2, **characterised in that** the apparatus comprises the at least one hood of the continuous flow heater, wherein the at least one hood comprises a viewing window (8).

4. Apparatus (1) for receiving a control electronics system (2) according to claim 3, **characterised in that** the display (7) can be pressed against the viewing window (8).

5. Apparatus (1) for receiving a control electronics system (2) according to one of the preceding claims, **characterised in that** the bearing block (5) has guides and/or counterdetents for at least one plug.

6. Apparatus (1) for receiving a control electronics system (2) according to one of the preceding claims, **characterised in that** the spring strut (6a; 6b) comprises a piping and/or a cabling.

7. Apparatus (1) for receiving a control electronics system (2) according to one of the preceding claims, **characterised in that** the apparatus has at least one latching hook (9a; 9b; 9c; 9d), by means of which the apparatus can be connected to the continuous flow heater (3).

8. Apparatus (1) for receiving a control electronics system (2) according to one of the preceding claims, **characterised in that** the apparatus has at least one guide pin (10a; 10b; 10c; 10d), by means of which the latching hooks (9a; 9b; 9c; 9d) can be stabilised.

## Revendications

1. Dispositif (1) destiné à loger une électronique de commande (2) d'un chauffe-eau instantané (3) électronique, le chauffe-eau instantané comprenant au moins un capot (4), **caractérisé en ce que** le dispositif (1) comprend au moins un support de palier (5) lequel comprend une électronique de commande (2), le dispositif (1) présentant au moins une jambe à ressort (6a ; 6b ; 6c ; 6d) au moyen de laquelle le support de palier (5) peut être pressé contre le capot (4).

2. Dispositif (1) destiné à loger une électronique de commande (2) selon la revendication 1, **caractérisé en ce que** l'électronique de commande (2) comprend au moins un écran (7).

3. Dispositif (1) destiné à loger une électronique de commande (2) selon la revendication 1 ou 2, **caractérisé en ce que** le dispositif comprend l'au moins un capot du chauffe-eau instantané, l'au moins un capot du chauffe-eau instantané comprenant une fenêtre de visualisation (8).

4. Dispositif (1) destiné à loger une électronique de commande (2) selon la revendication 3, **caractérisé en ce que** l'écran (7) peut être pressé contre la fenêtre de visualisation (8).

5. Dispositif (1) destiné à loger une électronique de commande (2) selon l'une quelconque des revendications précédentes, **caractérisé en ce que** le support de palier (5) présente des guidages et/ou des contre-enclenchements pour au moins un connecteur.

6. Dispositif (1) destiné à loger une électronique de commande (2) selon l'une quelconque des revendications précédentes, **caractérisé en ce que** la jambe à ressort (6a ; 6b) comprend une tuyauterie et/ou un câblage.

7. Dispositif (1) destiné à loger une électronique de commande (2) selon l'une quelconque des revendications précédentes, **caractérisé en ce que** le dispositif présente au moins un crochet d'encliquetage (9a ; 9b ; 9c ; 9d) au moyen duquel le dispositif peut être relié au chauffe-eau instantané.

8. Dispositif (1) destiné à loger une électronique de commande (2) selon l'une quelconque des revendications précédentes, **caractérisé en ce que** le dispositif présente au moins une tige de guidage (10a; 10b ; 10c; 10d) au moyen de laquelle le crochet d'encliquetage (9a ; 9b ; 9c ; 9d) peut être stabilisé.
